# EUROPEAN PATENT APPLICATION

(11) **EP 4 477 478 A1**
(43) Date of publication of application: **18.12.2024**
(21) Application number: 24181387.2
(22) Date of filing: 11.06.2024
(51) Int. Cl.: B60R 21/017, B60R 21/01

(54) **CRASH SWITCH CIRCUIT AND CRASH DETECTION SYSTEM INCLUDING THE SAME**

(30) Priority: 13.06.2023 KR 20230075626
(71) Applicant: Samsung SDI Co., Ltd., Yongin-si, Gyeonggi-do 17084 (KR)
(72) Inventor: Cho, Kyusung, 17084 Yongin-si, Gyeonggi-do (KR)
(74) Representative: Gulde & Partner

(57) **Abstract**

A crash switch circuit includes: a first switch including: an emitter to be supplied with a positive terminal voltage of a battery pack; a collector to output a crash output signal; and a base connected with a first node; a first resistor and a capacitor connected in parallel with each other between the emitter and the first node; and a diode including an anode to be supplied with a crash input signal from a crash sensor, and a cathode connected with the first node.

## Description

### BACKGROUND

### 1 Field

Aspects of embodiments of the present disclosure relate to a crash switch circuit, and a crash detection system including the crash switch circuit.

### 2 Description of Related Art

In the event of a vehicle accident such as a crash, it may be desirable to operate a safety function related to the crash. In order to operate the safety function, a crash signal detected for the crash is transmitted to safety apparatuses, and each safety apparatus transmits the crash signal to a main control unit (MCU) of a battery management system (BMS) and the like to thereby activate the safety function.

In addition, in order to further protect the life and safety of vehicle occupants, it may be desirable for safety apparatuses to transmit the crash signal from the detected crash to the MCU as quickly as possible.

The above information disclosed in this Background section is for enhancement of understanding of the background of the present disclosure, and therefore, it may contain information that does not constitute prior art.

It was an object of the present invention to provide a crash switch circuit that may transmit a crash signal as quickly as possible and operates without a separate power source, and to provide a crash detection system including the crash switch circuit.

### SUMMARY

The present invention is set out in the appended set of claims, wherein the drawings and respective description relate to advantageous embodiments thereof.

Chattering or noise may occur in a crash signal. As such, the safety apparatus that transmits the crash signal to a safety related circuit or the MCU may include a comparator with hysteresis characteristics or other logic gates.

Embodiments of the present disclosure are directed to a crash switch circuit that may detect a crash signal even if a problem occurs in the power of a comparator or other logic gate, and a crash detection system including the crash switch circuit.

Embodiments of the present disclosure are directed to a crash switch circuit that may transmit a crash signal by operating without a separate power source, and a crash detection system including the crash switch circuit.

According to the present invention, a crash switch circuit includes: a first switch including: an emitter configured to be supplied with a positive terminal voltage of a battery pack; a collector configured to output a crash output signal; and a base connected with a first node; a first resistor and a capacitor connected in parallel with each other between the emitter and the first node; and a diode including an anode configured to be supplied with a crash input signal from a crash sensor, and a cathode connected with the first node.

The crash switch circuit according to the present invention allows to control a safety related circuit by detecting a crash signal even when a power problem occurs by utilizing the crash switch circuit that may operate without a separate power source. In addition, it is possible to prevent or substantially prevent a malfunction by strengthening a tolerance to ripple noise, as well as a tolerance to chattering noise.

In an embodiment, the first switch may be configured to be turned on when the crash input signal reaches and maintains a reference voltage level more than a reference time from a voltage level that indicates a normal state.

In an embodiment, the reference time may be determined by a resistance value of the first resistor and a capacitance value of the capacitor.

In an embodiment, the diode may be a Zener diode with a breakdown voltage value; and the crash switch circuit further comprises a second resistor connected between the cathode of the diode and the first node, the reference voltage level may be determined by a resistance value of the first resistor, a resistance value of a second resistor, and the breakdown voltage value.

In an embodiment, the crash switch circuit may further include: a second switch including: a collector configured to output a crash conversion signal; an emitter connected to ground; and a base connected to a second node; a third resistor connected between the collector of the first switch and the second node; a fourth resistor connected between the second node and the ground; and a fifth resistor connected between a driving voltage and the collector of the second switch.

In an embodiment, the second switch may be an npn-type transistor.

In an embodiment, the crash switch circuit may further include a main switch.

In an embodiment, the main switch may add a hysteresis characteristic to output the crash output signal.

According to one or more embodiments of the present disclosure, a crash detection system includes: a crash switch circuit configured to output a crash output signal when a crash input signal indicating a crash detected by a crash sensor reaches and maintains a reference voltage level from a voltage level indicating a normal state more than a reference time; and a safety related circuit configured to be turned on or turned off based on the crash output signal, and perform a protection operation corresponding to the crash based on the crash output signal.

In an embodiment, the crash switch circuit may include: a first switch including: an emitter configured to be supplied with a positive terminal voltage of a battery pack; a collector configured to output a crash output signal; and a base connected to a first node; a first resistor and a capacitor connected in parallel with each other between the emitter and the first node; and a diode including an anode configured to be supplied with a crash input signal from a crash sensor, and a cathode connected to the first node.

In an embodiment, the reference time may be determined by a resistance value of the first resistor and a capacitance value of the capacitor.

In an embodiment, the diode may be a Zener diode having a breakdown voltage; the crash switch circuit further comprises a second resistor connected between the cathode of the diode and the first node; and the reference voltage level may be determined by a resistance value of the first resistor, a resistance value of the second resistor, and a value of the breakdown voltage.

In an embodiment, the crash detection system may further include: a main control unit (MCU) configured to control the safety related circuit; and a level converter configured to output a crash conversion signal to the MCU, the crash conversion signal being generated by changing a level of the crash output signal according to a driving voltage.

In an embodiment, the level converter may include: a second switch including: a collector configured to output a crash conversion signal; an emitter connected to ground; and a base connected to a second node; a third resistor connected between the collector of the first switch and the second node; a fourth resistor connected between the second node and the ground; and a fifth resistor connected between the driving voltage and the collector of the second switch.

In an embodiment, the crash output signal may be supplied to one end of the third resistor from the collector of the first switch.

According to one or more embodiments of the present disclosure, it may be possible to control a safety related circuit by detecting a crash signal even when a power problem occurs by utilizing the crash switch circuit that may operate without a separate power source.

According to one or more embodiments of the present disclosure, it may be possible to prevent or substantially prevent a malfunction by strengthening a tolerance to ripple noise, as well as a tolerance to chattering noise.

According to one or more embodiments of the present disclosure, it may be possible to set a high level and a low level and implement hysteresis, for a switch of such as a comparator or other logic gates, using a resistance value, a capacitance value, and the like.

### BRIEF DESCRIPTION OF THE DRAWINGS

The above and other aspects and features of the present disclosure will be more clearly understood from the following detailed description of the illustrative, non-limiting embodiments with reference to the accompanying drawings.
FIG. 1 is a block diagram of a crash detection system according to an embodiment.
FIG. 2 is a circuit diagram of the crash switch circuit shown in FIG. 1.
FIG. 3 is a circuit diagram of the crash switch circuit of FIG. 2 including a level conversion portion.
FIG. 4 is a flowchart of a crash signal output method according to an embodiment.
FIG. 5 is a graph illustrating a crash output signal according to ripple noise and a level of a crash conversion signal.
FIGS. 6-10 show experiment graphs according to one or more embodiments.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

Among components according to embodiments of the present disclosure, a program implemented as a set of instruction words embodying control algorithms necessary for controlling other configurations may be installed in a configuration that controls another configuration under a specific control condition. A control component may generate output data by processing input data and stored data according to the installed program. The control component may include a non-volatile memory to store programs and memory to store data.

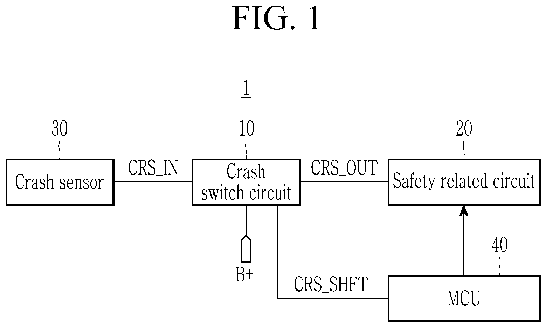

FIG. 1 is a block diagram of a crash detection system according to an embodiment.

Referring to FIG. 1, a crash detection system 1 may include a crash switch circuit 10, a safety related circuit 20, a crash sensor 30, and a main controller (MCU) 40.

The crash switch circuit 10 may receive a crash input signal CRS_IN and generate a crash output signal CRS_OUT corresponding to the crash input signal CRS_IN, and may generate a crash conversion signal CRS_SHFT corresponding to the crash output signal CRS_OUT by using a positive terminal voltage B+ of a battery pack as a power source.

The safety related circuit 20 may be a circuit that is controlled to be turned on or off according to the crash output signal CRS_OUT, and may perform a protection operation. For example, the safety related circuit 20 may be a main connector, such as a relay connected to a battery pack power supply. The protection operation may represent a control operation for protecting an external device connected to a battery system including a battery pack and/or a battery system in response to a crash.

In an embodiment, the crash switch circuit 10 may comprise a switch Q1 comprising: an emitter may be configured to be supplied with a positive terminal voltage B+ of a battery pack; a collector may be configured to output a crash output signal CRS_OUT; and a base may be connected with a first node N1; a resistor R1 and a capacitor C1 may be connected in parallel with each other between the emitter and the node N1; and a diode D1 which may comprise an anode configured to be supplied with a crash input signal CRS_IN from a crash sensor 30, and a cathode may be connected with the first node N1.

The crash sensor 30 may detect a crash, generate the crash input signal CRS_IN representing the detected crash, and input the crash input signal CRS_IN to the crash switch circuit 10.

In an embodiment, the crash switch circuit 10 may be configured to output a crash output signal CRS_OUT when a crash input signal CRS_IN indicating a crash detected by a crash sensor 30 reaches and maintains a reference voltage level from a voltage level indicating a normal state more than a reference time.

The MCU 40 may recognize that a crash has been detected based on the crash conversion signal CRS_SHFT, and control the safety related circuit 20 to perform the protection operation corresponding to the crash.

The crash switch circuit 10 may transmit the crash output signal CRS_OUT to the safety related circuit 20, and may generate the crash conversion signal CRS_SHFT to transmit the signal to the MCU 40.

In other words, the crash switch circuit 10 controls the safety related circuit 20 in hardware through the crash output signal CRS_OUT, transmits the crash conversion signal CRS_SHFT to the MCU 40, and controls the safety related circuit 20 in software through the MCU 40.

In addition, in FIG. 1, the MCU 40 is illustrated as controlling the safety related circuit 20, but the present disclosure is not limited thereto. In some embodiments, the MCU 40 may perform other various control operations related to the battery safety in addition to the safety related circuit 20 based on the crash conversion signal CRS_SHFT. For example, a control operation related to the battery safety may include a notification operation for notifying the user that a crash has been detected.

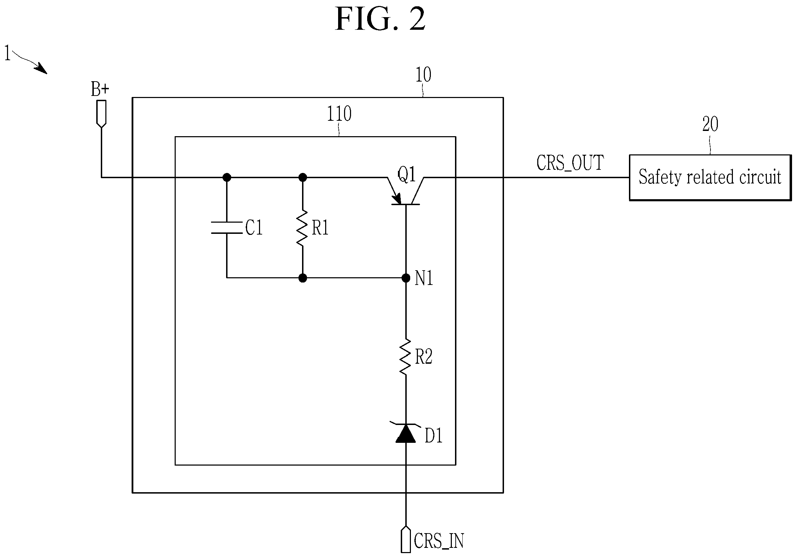

FIG. 2 is a circuit diagram of the crash switch circuit shown in FIG. 1.

Referring to FIG. 2, the crash switch circuit 10 may include a main switch 110.

The main switch 110 may remove noise from the crash input signal CRS_IN, and may add a hysteresis characteristic to output the crash output signal CRS_OUT. Here, the noise may be inrush noise, ripple noise, chattering noise, and/or the like.

The main switch 110 may transmit the crash output signal CRS_OUT to the safety related circuit 20.

According to an embodiment, the safety related circuit 20 may be configured to be turned on or turned off based on the crash output signal CRS_OUT, and may perform a protection operation corresponding to the crash based on the crash output signal CRS_OUT.

The crash input signal CRS_IN may use the positive terminal voltage B+ of a battery pack of a vehicle as a source (e.g., a power source). An off level of the crash input signal CRS_IN may be a high level within a range (e.g., a predetermined range) from the positive terminal voltage B+ of the battery pack, and an on level of the crash input signal CRS_IN may be a low level within the predetermined range from a ground voltage.

An off level of the crash output signal CRS_OUT may be a low level within the predetermined range from the ground voltage, and an on level of the crash output signal CRS_OUT may be a high level within the predetermined range from the positive terminal voltage B+ of the battery pack.

The main switch 110 may be a low active circuit that performs a switching operation at a low level. The main switch 110 may consider a normal state when the crash input signal CRS_IN is at a high level, and may indicate that a crash has occurred when the crash input signal CRS_IN is at a low level, and thus, a switching operation may be performed.

Hereinafter, the main switch 110 may be described in more detail in the context of a low active circuit as a representative example, but the present disclosure is not limited thereto.

The main switch 110 may include a capacitor C1, two resistors R1 and R2, a diode D1, and a switch Q1.

According to an embodiment, the switch Q1 may be configured to be turned on when the crash input signal CRS_IN reaches and maintains a reference voltage level more than a reference time from a voltage level that indicates a normal state.

According to an embodiment, the reference voltage level may be determined by a resistance value of the resistor R1, a resistance value of the resistor R2, and the breakdown voltage value.

The diode D1 may be a Zener diode. In a preferred embodiment, the diode D1 may be a Zener diode with a breakdown voltage value. The diode D1 may set an operation voltage of the switch Q1. The operation voltage of the switch Q1 may be a value considering a breakdown voltage value of the diode D1 and a base voltage of the switch Q1 from the positive terminal voltage B+ of the battery pack.

The switch Q1 may recognize a range from the voltage exceeding the threshold voltage value considering the breakdown voltage of the diode (D1) and the base voltage of the switch Q1 to the positive terminal voltage (B+) of the battery pack as a high level, which may be an off level. In addition, the switch Q1 may recognize a range below the threshold voltage value considering the breakdown voltage of diode D1 and the base voltage of switch Q1 from the positive terminal voltage B+ of the battery pack as a low level, which may be an on level, and may perform a switching operation.

For example, when the positive terminal voltage B+ of the battery pack is 12 V, the breakdown voltage of the diode D1 may be 6.2 V, and the base voltage of the switch Q1 may be 0.7 V, such that the operation voltage of the switch Q1 may be 5.1 V (e.g., 12-0.7-6.2 = 5.1). In this case, although the positive terminal voltage B+ of the battery pack is 12 V, the switch Q1 may recognize 5.1 V or higher as a high level.

Therefore, even when the voltage indicated by the crash input signal CRS_IN is actually dropped to some extent, the switch Q1 may recognize it as a high level. The switch Q1 may operate according to an operation voltage range determined based on the breakdown voltage of the diode D1.

The switch Q1 may be a PNP-type transistor.

The positive terminal voltage B+ of the battery pack may be supplied to an emitter of the switch Q1. The emitter of the switch Q1 may be connected with one end of the capacitor C1 and one end of the resistor R1. A base of the switch Q1 may be connected to a node N1. The node N1 may be connected with the other end of the capacitor C1 and one end of the resistor R2. Thus, the capacitor C1 and the resistor R1 may be connected in parallel with each other between the emitter of the switch Q1 and the node N1. A collector of the switch Q1 may output the crash output signal CRS_OUT.

The crash input signal CRS_IN may be supplied to an anode of the diode D1, and a cathode of the diode D1 may be connected to the node N1. The cathode of the diode D1 may be connected with the other end of the resistor R2 of which the one end thereof is connected to the node N1.

The capacitor C1 may form ripple noise and hysteresis in the main switch 110. In addition, the capacitor C1 may secure inrush noise tolerance and hysteresis with the two resistors R1 and R2.

The capacitor C1 may accumulate energy corresponding to a voltage difference between the positive terminal voltage B+ of the battery pack and the crash input signal CRS_IN.

The off level of the crash input signal CRS_IN may correspond to the value of the positive terminal voltage B+ of the battery pack, and thus, there may be little or no voltage difference, but if the crash input signal CRS_IN has the on level, the voltage difference between the positive terminal voltage B+ of the battery pack and the crash input signal CRS_IN may be generated.

Therefore, at a beginning when the voltage value indicated by the crash input signal CRS_IN changes from the off level to the on level, the switch Q1 may not perform a switching operation because a current flows through the capacitor C1 and the resistor R2.

When the voltage value indicated by the crash input signal CRS_IN is changed and maintained in that state for more than a reference time (e.g., a predetermined reference time), a current flows through the resistor R1 and the base of switch Q1, thus, allowing the switch Q1 to perform the switching operation. Here, the reference time may be a value determined by a time constant according to a resistance value of the resistor R1 and a capacitance value of capacitor C1.

As such, the switch Q1 may not perform the switching operation for ripple noise that may occur and disappear within the reference time according to the characteristics of the capacitor C1.

The reference time may be changed by the time constant according to the resistance value of the resistor R1 and the capacitance value of the capacitor C1.

An ON operating voltage at which the switch Q1 is turned on may be determined by the resistance value of the resistor R1, the capacitance value of the capacitor C1, and the breakdown voltage value of the diode D1. For example, the reference voltage may be determined by a time constant according to the resistance value of the resistor R1 and the capacitance value of the capacitor C1, and the breakdown voltage value of the diode D1.

An OFF operating voltage at which the switch Q1 is turned off may also be determined by the resistance value of the resistor R1, the capacitance value of the capacitor C1, and the breakdown voltage value of the diode D1.

The switch Q1 may be turned on when the crash input signal CRS_IN reaches the reference voltage from a voltage exceeding the reference voltage. Because the time when the crash input signal CRS_IN reaches the reference voltage is different from the time when the voltage value indicated by the crash input signal CRS_IN is outside the predetermined voltage range based on the off level, the main switch 110 may also have hysteresis characteristics.

The switch Q1 is turned off when the crash input signal CRS_IN reaches the OFF operating voltage from a voltage below the OFF operating voltage, and the time when the crash input signal CRS_IN reaches the off operating voltage may be different from the time when the voltage value indicated by the crash input signal CRS_IN is outside a voltage range (e.g., a predetermined voltage range) based on the on level.

Because the main switch 110 may be a low active circuit, a voltage level of each of the reference voltage and the OFF operating voltage may be lower than the high level, which is the off level of the crash input signal CRS_IN, and higher than the low level, which is the on level of the crash input signal CRS_IN.

The level of the reference voltage and the level of the off operating voltage may be determined differently depending on the resistance value of each of the two resistors R1 and R2 and the breakdown voltage value of the diode D1.

The two resistors R1 and R2 may set an operation current for the switching operation of the switch Q1. The main switch 110 may set the degree of noise tolerance and a hysteresis value by a combination of the two resistors R1 and R2 and the capacitor C1.

The main switch 110 may finely adjust the operating voltage value of the switch Q1, which is determined by the breakdown voltage of diode D1, according to the time constant of the two resistors R1 and R2.

For example, when the resistance value of each of the two resistors R1 and R2 increases, the current flowing through the two resistors R1 and R2 decreases, and accordingly, the switch Q1 may perform the switching operation at a voltage level when the voltage of the crash input signal CRS_IN is lower by a degree (e.g., a predetermined degree) than the operating voltage level set by the diode D1.

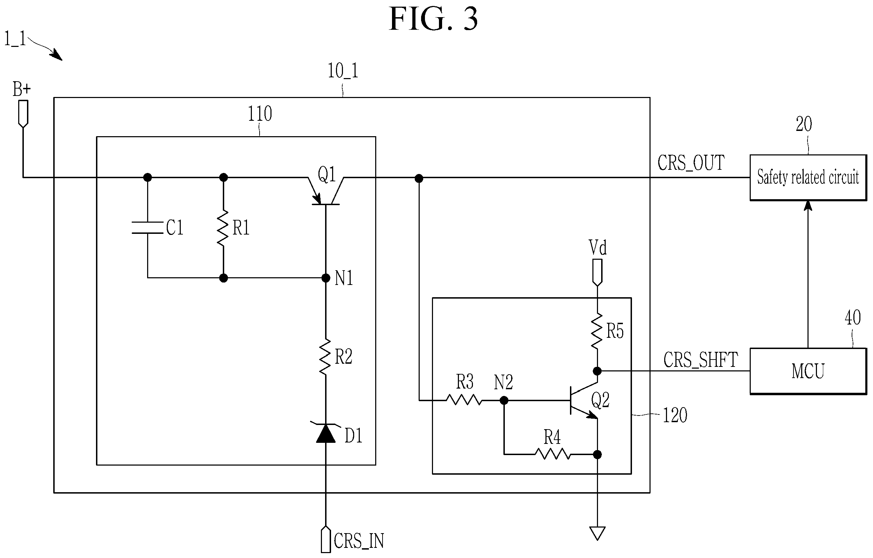

FIG. 3 is a circuit diagram of the crash switch circuit of FIG. 2 including a level conversion portion.

With reference to FIG. 3 hereinafter, redundant description of the same or substantially the same components as those described above may not be repeated.

Referring to FIG. 3, a crash detection system 1_1 according to an embodiment may include a crash switch circuit 10_1. The crash switch circuit 10_1 may include the main switch 110 and a level converter 120.

The crash detection system 1_1 of FIG. 3 may be an example of the crash detection system 1 illustrated in FIG. 1.

According to an embodiment, the crash switch circuit 10_1 may further comprise a switch Q2 which may comprise a collector may be configured to output a crash conversion signal CRS_SHFT; an emitter may be connected to ground; and a base may be connected to a node N2; a resistor R3 may be connected between the collector of the switch Q1 and the node N2; a resistor R4 may be connected between the node N2 and the ground; and a resistor R5 may be connected between a driving voltage Vd and the collector of the switch Q2.

The main switch 110 may receive the crash input signal CRS_IN and generate the crash output signal CRS_OUT corresponding to the crash input signal CRS_IN by using the positive terminal voltage B+ of a battery pack as a power source.

The main switch 110 may transmit the crash output signal CRS_OUT to the safety related circuit 20.

The level converter 120 may output a crash conversion signal CRS_SHFT that changes a level of the crash output signal CRS_OUT according to a driving voltage (e.g., a predetermined driving voltage) Vd based on the crash output signal CRS_OUT. The driving voltage Vd may be at the same or substantially the same level as that of the crash input signal CRS_IN.

The driving voltage Vd may be a value that allows an operating level of the crash conversion signal CRS_SHFT to be transmitted to a time to live (TTL) signal level element of the MCU 40. For example, the driving voltage Vd may be 3.3 V or 5 V.

The level converter 120 may transmit the crash conversion signal CRS_SHFT to the MCU 40.

The level converter 120 may include three resistors R3 to R5 and a switch Q2.

The switch Q2 may be an NPN-type transistor.

A collector of the switch Q2 outputs the crash conversion signal CRS_SHFT, a base of the switch Q2 is connected to a node N2, and an emitter of the switch Q2 may be connected to the ground. The resistor R3 may be connected between the collector of the switch Q1 and the node N2. The resistor R4 may be connected between the node N2 and the ground. The crash output signal CRS_OUT may be supplied to one end of the resistor R3 from the collector of the switch Q1.

The resistor R5 may be connected between the driving voltage Vd and the collector of the switch Q2.

When the crash output signal CRS_OUT is at an off level, the switch Q2 may output the crash conversion signal CRS_SHFT of the off level without being turned on in a turned-off state. The off level of the crash conversion signal CRS_SHFT may be a high level within a range (e.g., a predetermined range) from the driving voltage Vd.

When the crash output signal CRS_OUT is changed from the off level to the on level, the switch Q2 is turned on, and thus, outputs the crash conversion signal CRS_SHFT at an on level. The on level of the crash conversion signal CRS_SHFT may be a low level within a range (e.g., a predetermined range) from the ground voltage.

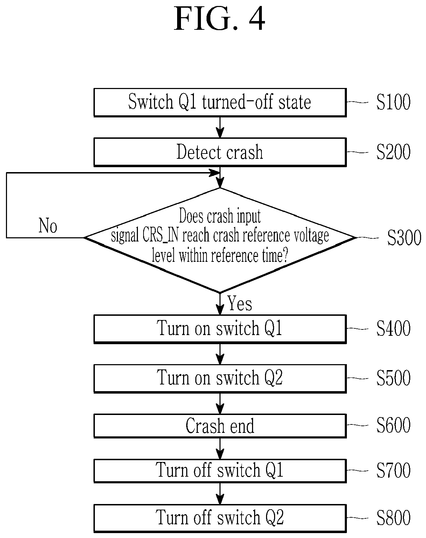

FIG. 4 is a flowchart of a crash signal output method according to an embodiment.

With reference to FIG. 4 hereinafter, redundant description of the same or substantially the same components as those described above may not be repeated.

Referring to FIG. 4, the switch Q1 may be in a turned-off state (S100).

A crash may be detected by the crash sensor 30 (S200).

When a crash starts to be detected by the crash sensor 30, the crash input signal CRS_IN may deviate from the high level indicating a normal state by exceeding a predetermined range. The main switch 110 may remove noise from the crash input signal CRS_I N and generate the crash output signal CRS_OUT by forming a hysteresis.

The switch Q1 may operate differently depending on whether the crash input signal CRS_IN reaches and maintains the reference voltage level more than the reference time from the high level, which is the off level (S300).

The switch Q1 may remove noise from the crash input signal CRS_IN, form a hysteresis, and then output the crash output signal CRS_OUT.

The reference time may be determined according to the resistance value of the resistor R1 included in the main switch 110 and the capacitance value of the capacitor C1.

When the crash input signal CRS_IN does not maintain the reference voltage level more than the reference time (e.g., NO at S300), the switch Q1 may not perform the switching operation, and may continue to monitor the crash input signal CRS_IN (e.g., S300 may be repeated). As such, according to the characteristics of the capacitor C1, the switch Q1 may not perform the switching operation due to ripple noise in which the crash input signal CRS_IN returns to the high level again within the reference time.

When the crash input signal CRS_IN maintains the reference voltage level more than the reference time (e.g., YES at S300), the switch Q1 may be turned on (S400).

The switch Q1 may be turned on when the crash input signal CRS_IN decreases from a voltage exceeding the reference voltage to less than the reference voltage by the hysteresis characteristic according to the two resistors R1 and R2 and the capacitor C1.

When the switch Q1 is turned on, the collector of the switch Q1 may output the crash output signal CRS_OUT of the on level.

When the crash output signal CRS_OUT is changed to the high level (which is the on level) from the low level (which is the off level), the switch Q2 is turned on (S500), and thus, the crash conversion signal CRS_SHFT may be changed to the low level (which is the on level) from the high level (which is the off level).

After the switch Q2 is turned on, the crash detected by the crash sensor 30 may be terminated (S600).

When the crash detected by the crash sensor 30 is terminated, it may be determined that a voltage value represented by the crash input signal CRS_IN increases from the low level, which is the on level, to an amount that exceeds the predetermined voltage range.

When the crash input signal CRS_IN reaches the OFF operating voltage level from the low level, which is the on level, the switch Q1 may be turned off (S700).

When the switch Q1 is turned off, the collector of the switch Q1 may output the crash output signal CRS_OUT of the low level.

When the crash output signal CRS_OUT is changed from the high level (which is the on level) to the low level (which is the off level), the switch Q2 is turned off (S800), and the crash conversion signal CRS_SHFT may be changed from the low level (which is the on level) to the high level (which is the off level).

In the method described above with reference to FIG. 4, the crash output signal CRS_OUT output from the main switch 110 may be input to the safety related circuit 20, and the crash conversion signal CRS_SHFT output from the level converter 120 may be input to the MCU 40. The safety related circuit 20 may be turned on or turned off based on the crash output signal CRS_OUT to operate the protection operation. The MCU 40 recognizes that a crash is detected based on the crash conversion signal CRS_SHFT, and may perform a corresponding protection operation.

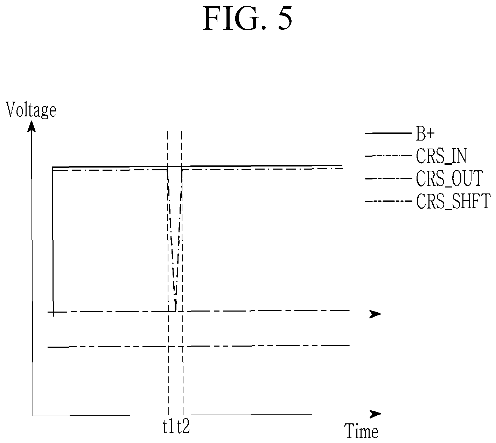

FIG. 5 is a graph illustrating a crash output signal according to ripple noise and a level of the crash conversion signal.

Referring to FIG. 5, ripple noise may be included in the crash input signal CRS_IN during a period from a time t1 to a time t2. In this case, the period from the time t1 to the time t2 may be within the reference period, and thus, the switch Q1 of the main switch 110 may be turned on to output a crash output signal CRS_OUT of the off level. The voltage level indicated by the crash output signal CRS_OUT of the off level may be within the predetermined range from the ground voltage.

The level converter 120 may output the crash conversion signal CRS_SHFT of the off level based on the crash output signal CRS_OUT. The voltage level indicated by the crash conversion signal CRS_SHFT of the off-level may be within a range (e.g., a predetermined range) from the level of the driving voltage Vd shown in FIG. 3.

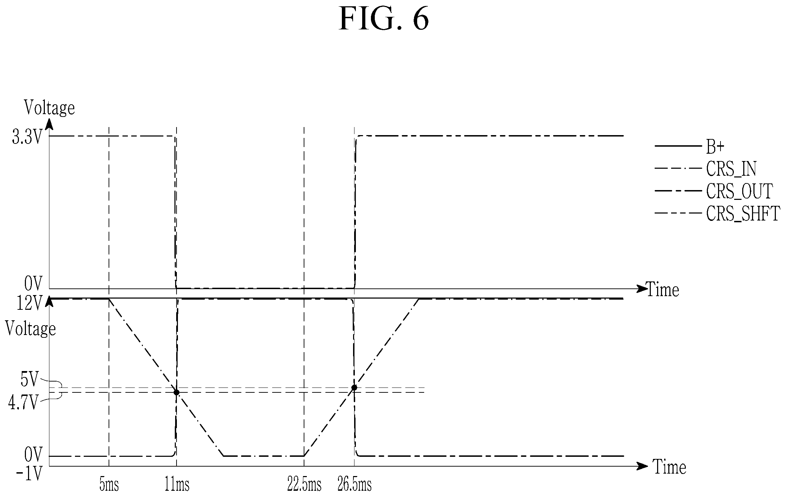

Hereinafter, a change of the reference voltage according to resistance values of the two resistors R1 and R2 will be described in more detail with reference to FIG. 6 through FIG. 10.

FIGS. 6 through 10 show experiment graphs according to one or more embodiments.

In FIG. 6 to FIG. 10, it is assumed that a capacitance of the capacitor C1 is 47 nF, the switch Q1 is a transistor, the diode D1 is a Zener diode having a breakdown voltage of 6.2 V, and the driving voltage Vd is 3.3 V.

In the experimental example of FIG. 6, a reference voltage may be derived when the resistance value of each of the two resistors R1 and R2 is 4.3 kΩ.

Referring to FIG. 6, when the time is 0 ms, the crash input signal CRS_IN is in a high level, which is the off level, and the crash output signal CRS_OUT is in a low level, which is the off level. The off level of the crash input signal CRS_IN is 12 V corresponding to the positive terminal voltage B+ of the battery pack.

When the crash input signal CRS_IN reaches the reference voltage at 11 ms after being decreased starting from 5 ms, the crash output signal CRS_OUT is changed to the high level, which is the on level.

The on level of the crash output signal CRS_OUT is 12 V corresponding to the positive terminal voltage B+ of the battery pack. In the experimental example of FIG. 6, the reference voltage is 4.7 V.

When the crash output signal CRS_OUT is changed to the high level from the low level, the crash conversion signal CRS_SHFT is changed to the low level, which is the on level.

In addition, the crash output signal CRS_OUT is changed to the low level, which is the off level, when the crash input signal CRS_IN reaches the off operating voltage at 26.5 ms after being increased starting from 22.5 ms. In the experimental example of FIG. 6, the off operating voltage is 5 V.

When the crash output signal CRS_OUT is changed to the low level from the high level, the crash conversion signal CRS_SHFT is changed to the high level, which is the off level. The off level of the crash conversion signal CRS_SHFT is 3.3 V corresponding to the driving voltage Vd.

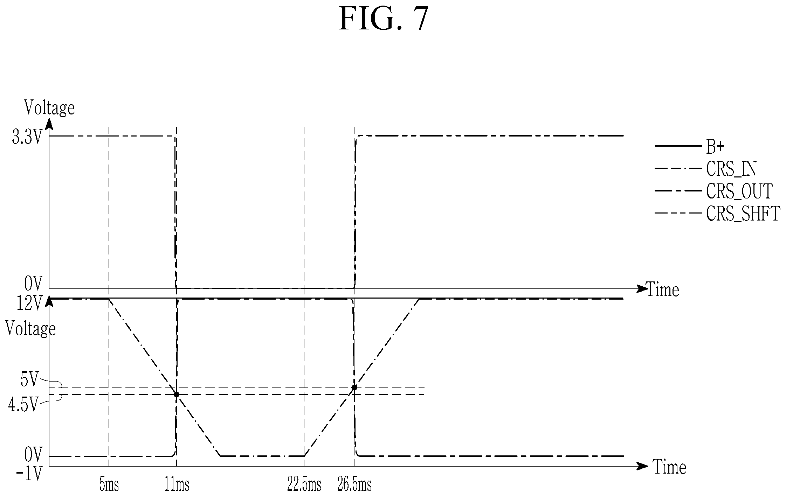

In the experimental example of FIG. 7, a reference voltage may be derived in the case that the resistance values of the two resistors R1 and R2 are 10 kΩ.

Referring to FIG. 7, when the time is 0 ms, the crash input signal CRS_IN is in a high level, which is the off level, and the crash output signal CRS_OUT is in a low level, which is the off level.

When the crash input signal CRS_IN reaches the reference voltage at 11 ms after being decreased starting from 5 ms, the crash output signal CRS_OUT is changed to the high level, which is the on level. In the experimental example of FIG. 7, the reference voltage is 4.5 V.

When the crash output signal CRS_OUT is changed to the high level from the low level, the crash conversion signal CRS_SHFT is changed to the low level, which is the on level.

In addition, the crash output signal CRS_OUT is changed to the low level, which is the off level, when the crash input signal CRS_IN reaches the off operating voltage at 26.5 ms after being increased starting from 22.5 ms. In the experimental example of FIG. 7, the off operating voltage is 5 V.

When the crash output signal CRS_OUT is changed to the low level from the high level, the crash conversion signal CRS_SHFT is changed to the high level, which is the off level.

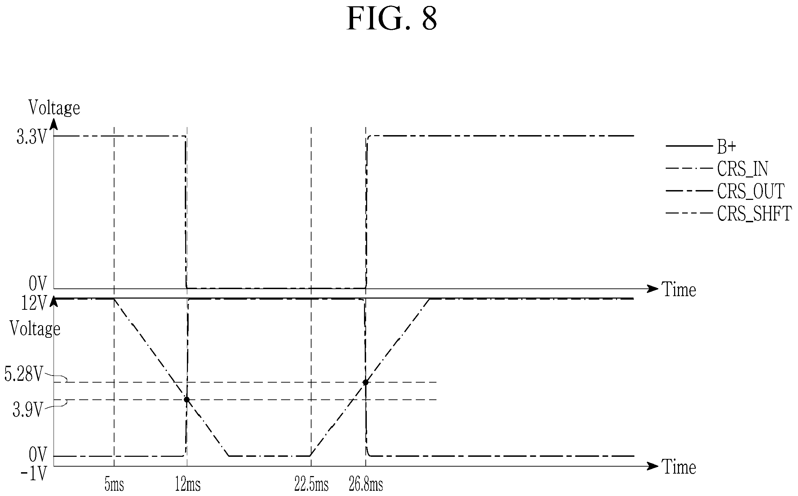

In the experimental example of FIG. 8, a reference voltage may be derived in the case that the resistance values of the two resistors R1 and R2 are 43 kΩ.

Referring to FIG. 8, when the time is 0 ms, the crash input signal CRS_IN is in a high level, which is the off level, and the crash output signal CRS_OUT is in a low level, which is the off level.

When the crash input signal CRS_IN reached the reference voltage at 12 ms after being decreased starting from 5 ms, the crash output signal CRS_OUT is changed to the high level, which is the on level. In the experimental example of FIG. 8, the reference voltage is 3.9 V.

When the crash output signal CRS_OUT is changed to the high level from the low level, the crash conversion signal CRS_SHFT is changed to the low level, which is the on level.

In addition, the crash output signal CRS_OUT is changed to the low level, which is the off level, when the crash input signal CRS_IN reaches the off operating voltage at 26.8 ms after being increased starting from 22.5 ms. In the experimental example of FIG. 8, the off operating voltage is 5.28 V.

When the crash output signal CRS_OUT is changed to the low level from the high level, the crash conversion signal CRS_SHFT is changed to the high level, which is the off level.

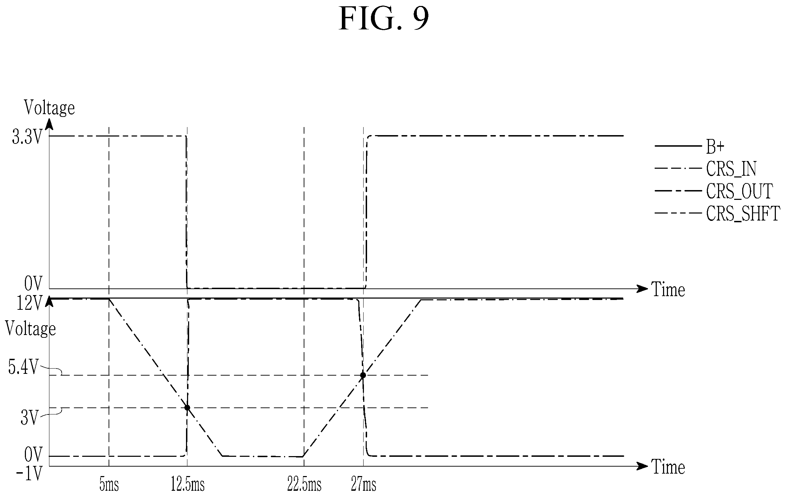

In the experimental example of FIG. 9, a reference voltage may be derived in the case that the resistance values of the two resistors R1 and R2 are 100 kΩ.

Referring to FIG. 9, when the time is 0 ms, the crash input signal CRS_IN is in a high level, which is the off level, and the crash output signal CRS_OUT is in a low level, which is the off level.

When the crash input signal CRS_IN reached the reference voltage at 12.5 ms after being decreased starting from 5 ms, the crash output signal CRS_OUT is changed to the high level, which is the on level. In the experimental example of FIG. 9, the reference voltage is 3 V.

When the crash output signal CRS_OUT is changed to the high level from the low level, the crash conversion signal CRS_SHFT is changed to the low level, which is the on level.

In addition, the crash output signal CRS_OUT is changed to the low level, which is the off level, when the crash input signal CRS_IN reaches the off operating voltage at 27 ms after being increased starting from 22.5 ms. In the experimental example of FIG. 9, the off operating voltage is 5.4 V.

When the crash output signal CRS_OUT is changed to the low level from the high level, the crash conversion signal CRS_SHFT is changed to the high level, which is the off level.

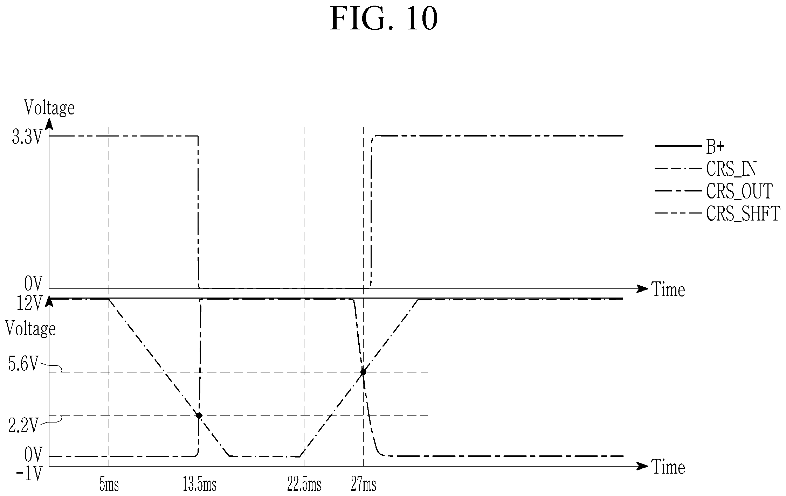

In the experimental example of FIG. 10, a reference voltage may be derived in the case that the resistance values of the two resistors R1 and R2 are 200 kΩ.

Referring to FIG. 10, when the time is 0 ms, the crash input signal CRS_IN is in a high level, which is the off level, and the crash output signal CRS_OUT is in a low level, which is the off level.

When the crash input signal CRS_IN reached the reference voltage at 13.5 ms after being decreased starting from 5 ms, the crash output signal CRS_OUT is changed to the high level, which is the on level. In the experimental example of FIG. 10, the reference voltage is 2.2 V.

When the crash output signal CRS_OUT is changed to the high level from the low level, the crash conversion signal CRS_SHFT is changed to the low level, which is the on level.

In addition, the crash output signal CRS_OUT is changed to the low level, which is the off level, when the crash input signal CRS_IN reaches the off operating voltage at 27 ms after being increased starting from 22.5 ms. In the experimental example of FIG. 10, the off operating voltage is 5.6 V.

When the crash output signal CRS_OUT is changed to the low level from the high level, the crash conversion signal CRS_SHFT is changed to the high level, which is the off level.

Referring to the experimental examples of FIG. 6 through FIG. 10, as the resistance value of each of the two resistors R1 and R2 increases, the reference voltage at which the switch Q1 is turned on is decreased.

The foregoing is illustrative of some embodiments of the present disclosure, and is not to be construed as limiting thereof. Although some embodiments have been described, those skilled in the art will readily appreciate that various modifications are possible in the embodiments. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein.

### Description of symbols

1, 1_1: crash detection system
10, 10_1: crash switch circuit
110: main switch
120: level converter
20: safety related circuit
30: crash sensor
40: main control unit (MCU)

## Claims

1. A crash switch circuit (10) comprising:
a first switch (Q1) comprising:
an emitter configured to be supplied with a positive terminal voltage (B+) of a battery pack;
a collector configured to output a crash output signal (CRS_OUT); and
a base connected with a first node (N1);
a first resistor (R1) and a capacitor (C1) connected in parallel with each other between the emitter and the first node (N1); and
a diode (D1) comprising an anode configured to be supplied with a crash input signal (CRS_IN) from a crash sensor (30), and a cathode connected with the first node (N1).

2. The crash switch circuit (10) as claimed in claim 1, wherein the first switch (Q1) is configured to be turned on when the crash input signal (CRS_IN) reaches and maintains a reference voltage level more than a reference time from a voltage level that indicates a normal state.

3. The crash switch circuit (10) as claimed in claim 1 or 2, wherein the reference time is determined by a resistance value of the first resistor (R1) and a capacitance value of the capacitor (C1).

4. The crash switch circuit (10) as claimed in any of claims 1 to 3, wherein:
the diode (D1) is a Zener diode with a breakdown voltage value;
the crash switch circuit further comprises a second resistor (R2) connected between the cathode of the diode and the first node; and
the reference voltage level is determined by a resistance value of the first resistor (R1), a resistance value of the second resistor (R2), and the breakdown voltage value.

5. The crash switch circuit (10_1) as claimed in claim 1, further comprising:
a second switch (Q2) comprising:
a collector configured to output a crash conversion signal (CRS_SHFT);
an emitter connected to ground; and
a base connected to a second node (N2);
a third resistor (R3) connected between the collector of the first switch (Q1) and the second node (N2);
a fourth resistor (R4) connected between the second node (N2) and the ground; and
a fifth resistor (R5) connected between a driving voltage (Vd) and the collector of the second switch (Q2).

6. The crash switch circuit (10_1) as claimed in claim 5, wherein the switch (Q2) is an NPN-type transistor.

7. The crash switch circuit (10, 10_1) as claimed in any of claims 1 to 6, further comprising a main switch (110).

8. The crash switch circuit (10, 10_1) as claimed in any of claims 1 to 7, wherein the main switch (110) adds a hysteresis characteristic to output the crash output signal (CRS_OUT).

9. A crash detection system (1) comprising:
a crash switch circuit (10) configured to output a crash output signal (CRS_OUT) when a crash input signal (CRS_IN) indicating a crash detected by a crash sensor (30) reaches and maintains a reference voltage level from a voltage level indicating a normal state more than a reference time; and
a safety related circuit (20) configured to be turned on or turned off based on the crash output signal (CRS_OUT), and performs a protection operation corresponding to the crash based on the crash output signal (CRS_OUT).

10. The crash detection system (1) as claimed in claim 9, wherein the crash switch circuit (10) comprises:
a first switch (Q1) comprising:
an emitter configured to be supplied with a positive terminal voltage (B+) of a battery pack;
a collector configured to output a crash output signal (CRS_OUT); and
a base connected to a first node (N1);
a first resistor (R1) and a capacitor (C1) connected in parallel with each other between the emitter and the first node (N1); and
a diode (D1) comprising an anode configured to be supplied with a crash input signal (CRS_IN) from a crash sensor (30), and a cathode connected to the first node (N1).

11. The crash detection system (1) as claimed in claim 10, wherein the reference time is determined by a resistance value of the first resistor (R1) and a capacitance value of the capacitor (C1).

12. The crash detection system (1) as claimed in claim 10 or 11, wherein:
the diode (D1) is a Zener diode having a breakdown voltage; and
the reference voltage level is determined by a resistance value of the first resistor (R1), a resistance value of a second resistor (R2), and a value of the breakdown voltage.

13. The crash detection system (1_1) as claimed in any of claims 10 to 12, further comprising:
a main control unit, MCU (40) configured to control the safety related circuit (20); and
a level converter (120) configured to output a crash conversion signal (CRS_SHFT) to the main control unit, MCU (40), the crash conversion signal (CRS_SHFT) being generated by changing a level of the crash output signal (CRS_OUT) according to a driving voltage (Vd).

14. The crash detection system (1_1) as claimed in claim 13, wherein the level converter (120) comprises:
a second switch (Q2) comprising:
a collector configured to output a crash conversion signal (CRS_SHFT);
an emitter connected to ground; and
a base connected to a second node (N2);
a third resistor (R3) connected between the collector of the first switch (Q1) and the second node (N2);
a fourth resistor (R4) connected between the second node (N2) and the ground; and
a fifth resistor (R5) connected between the driving voltage (Vd) and the collector of the second switch (Q2).

15. The crash detection system (1_1) as claimed in claim 14, wherein the crash output signal (CRS_OUT) is supplied to one end of the resistor (R3) from the collector of the first switch (Q1).
